Europäisches Patentamt

European Patent Office

Office européen des brevets

(19)

(11) Veröffentlichungsnummer: **0 264 469 B1**

(12) **EUROPÄISCHE PATENTSCHRIFT**

(45) Veröffentlichungstag der Patentschrift: **15.01.92**

(21) Anmeldenummer: **86114535.7**

(22) Anmeldetag: **21.10.86**

(51) Int. Cl.⁵: **H01L 25/065**, H01L 23/40, H01L 23/528

(54) **Anordnung zur Verdoppelung der Packungsdichte monolithisch integrierte Schaltungen enthaltender Halbleiterchips.**

(43) Veröffentlichungstag der Anmeldung:
**27.04.88 Patentblatt 88/17**

(45) Bekanntmachung des Hinweises auf die Patenterteilung:
**15.01.92 Patentblatt 92/03**

(84) Benannte Vertragsstaaten:
**DE FR GB**

(56) Entgegenhaltungen:
**FR-A- 2 306 530**
**US-A- 4 046 442**
**US-A- 4 235 285**

**IBM TECHNICAL DISCLOSURE BULLETIN, Band 21, Nr. 10, März 1979, Seiten 4023-4024, New York, US; B.MARTIN et al.: "Hermetic hybrid module"**

**IBM TECHNICAL DISCLOSURE BULLETIN, Band 20, Nr. 11B, April 1978, Seiten 4771-4773, New York, US; D.CRAWFORD et al.: "High density multilayer ceramic module"**

(73) Patentinhaber: **International Business Machines Corporation**
**Old Orchard Road**
**Armonk, N.Y. 10504(US)**

(72) Erfinder: **Perske, Manfred**
**Hohenstaufenstrasse 6/2**
**W-7032 Sindelfingen(DE)**
Erfinder: **Maier, Horst, Dipl.-Ing.**
**Schickhardtstrasse 26**
**W-7034 Gärtringen(DE)**
Erfinder: **Landrock, Jürgen**
**Bismarckstrasse 25-1**
**W-7039 Weil i. Schönbuch(DE)**
Erfinder: **Tandjung, Halim, Dipl.-Ing.**
**Nürtingerstrasse 75**
**W-7030 Böblingen(DE)**

(74) Vertreter: **Teufel, Fritz, Dipl.-Phys. et al**
**IBM Deutschland GmbH Patentwesen und Urheberrecht Schönaicher Strasse 220**
**W-7030 Böblingen(DE)**

IBM TECHNICAL DISCLOSURE BULLETIN, Band 22, Nr. 3, August 1979, Seiten 960-961, New York, US; F.J.DeMAINE et al.: "Attachable heat sink for pluggable modules"

IBM TECHNICAL DISCLOSURE BULLETIN, Band 10, Nr. 8, Januar 1968, Seite 1242, New York, US; J.M.MULLIGAN: "Snap-on heat exchanger"

IBM TECHNICAL DISCLOSURE BULLETIN, Band 19, Nr. 9, Februar 1977, Seiten 3321-3322, New York, US; N.C.ARVANITAKIS: "Modular organic carrier"

## Beschreibung

Die Erfindung betrifft eine Trägeranordnung für monolithisch integrierte Schaltungen enthaltende Halbleiterchips, die auf ein elektrisch isolierendes Substrat aufgelötet sind.

Es ist bekannt, die monolithisch integrierte Halbleiterschaltungen enthaltenden Halbleiterchips auf der Oberseite eines elektrisch isolierenden Substrates, z. B.eines Keramiksubstrates, mittels Lötverbindungen zu befestigen. Das Substrat wird seinerseits über Steckerstifte in Bohrungen eines mit Leiterzügen versehenen Substratträgers, der auch als Grundkarte bezeichnet wird und mehrere Substrate aufnimmt, eingelötet.

Die genannte Art der Befestigung der Substrate auf der Grundkarte mittels Verbindungsstiften verhindert es, daß die Unterseite des die Halbleiterchips aufnehmenden Substrates ebenfalls mit Halbleiterchips und Leiterzügen versehen werden kann, wodurch eine Verdoppelung der Packungsdichte der Halbleiterchips verhindert wird.

Hier will die Erfindung Abhilfe schaffen. Die Erfindung, wie sie in den Ansprüchen gekennzeichnet ist, löst die Aufgabe, eine Anordnung zur Verdoppelung der Packungsdichte monolithisch integrierte Schaltungen enthaltender Halbleiterchips zu schaffen. Außer der Verdoppelung der Packungsdichte ist als weiterer durch die Erfindung erreichter Vorteil zu nennen, daß im Fehlerfall nur das Substrat mit der fehlerhaften Schaltung ausgetauscht werden muss und nicht die Grundkarte mit den übrigen Substraten, deren Halbleiterschaltungen fehlerfrei sind.

Im folgenden wird die Erfindung anhand eines Ausführungsbeispieles in Verbindung mit den Zeichnungen näher erläutert, von denen zeigen:

Fig. 1 eine Schnittansicht der erfindungsgemäßen Anordnung zur Verdoppelung der Packungsdichte von Halbleiterschaltungen, und

Fig. 2 eine Draufsicht auf eine mit einer Aussparung versehene Grundkarte, die längs der Aussparungsränder auf ihrer Ober- und Unterseite mit Kontaktflächen und an ihrer Unterseite zusätzlich mit Kontaktfedern versehen ist, die etwas in die Aussparung hineinragen.

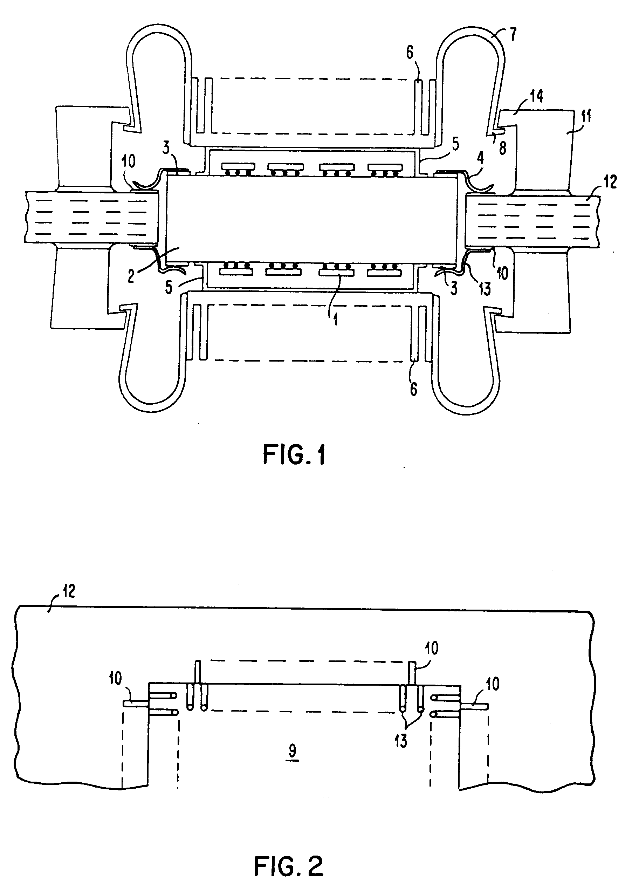

Wie Fig. 1 zeigt sind mehrere Halbleiterchips (1) sowohl auf die Ober- als auch die Unterseite eines Substrates (2) aus elektrisch gut isolierendem Material, z. B. Keramik, aufgelötet. Die Verbindung der Halbleiterchips (1) untereinander und mit der Betriebsspannungsquelle erfolgt über nicht dargestellte Leiterzüge die sowohl auf der Ober- als auch auf der Unterseite des Substrates (2) verlaufen, im Substrat verknüpft sind, und in am Rande des Substrates (2) regelmäßig angeordneten Kontaktflächen (3) enden bzw. von ihnen ausgehen. Die aus Kupfer bestehenden Kontaktflächen (3) sind zur Erzielung eines guten elektrischen Kontaktes mit Gold plattiert. An die Kontaktflächen (3) auf der Oberseite des Substrates (2) sind Kontaktfedern (4) aus einer Kupfer-Beryllium-Legierung angelötet. Die Kontaktfedern (4) sind im Kontaktbereich goldplattiert. Die Halbleiterchips (1) auf der Ober- und Unterseite sind durch eine Abdeckhaube (5) geschützt, auf der ein Kühlkörper (6) befestigt ist. An zwei gegenüberliegenden Stirnseiten des Kühlkörpers (6) sind zwei Verriegelungsbügel (7) aus einem federnden Material wie Kupfer-Beryllium oder Phosphorbronze oder einem Kunststoffmaterial befestigt, die an ihrem freien Ende mit einem Vorsprung (8) versehen sind.

Das so mit Halbleiterchips, Leiterzügen, Abdeckhauben und Kühlkörpern versehene Substrat (2) wird in eine Aussparung (9) der Grundkarte (12) eingesetzt. Die Ränder der Aussparung (9) der Grundkarte (12) sind sowohl auf der Ober- als auch auf der Unterseite ebenfalls mit goldplattierten Kontaktflächen (10) aus Kupfer versehen. An die Kontaktflächen (10) auf der Unterseite sind Kontaktfedern (13) aus einer Kupfer-Beryllium-Legierung angelötet, die etwas in die Aussparung (9) hineinragen, das Substrat (2) aufnehmen und mit dessen Kontaktflächen (3) Kontakt machen. Die Kontaktfedern (4) auf der Oberseite des Substrates (2) stellen den Kontakt mit den Kontaktflächen (10) mit den Rändern der Aussparung (9) der Grundkarte (12) her. Auf ihrer Ober- und Unterseite sind an zwei gegenüberliegenden Stellen zwei Verriegelungspfosten (11) angebracht, die mit schrägabfallenden Nasen (14) versehen sind. Unter sie werden die schräg nach oben weisenden Vorsprünge (8) der Verriegelungsbügel (7) gedrückt. Dadurch wird der erforderliche Kontaktdruck für eine lötfreie elektrische Verbindung und für eine sichere Halterung der Substrate in der Aussparung der Grundkarte gewährleistet.

## Patentansprüche

1. Trägeranordnung für monolithisch integrierte Schaltungen enthaltende Halbleiterchips (1), die auf ein elektrisch isolierendes Substrat (2) aufgelötet sind, das mit internen und externen Leiterzügen versehen ist, über die Eingangs- und Ausgangssignale sowie die Versorgungsspannungen zugeführt werden und das mit einer Abdeckhaube (5) und daran befestigtem Kühlkörper (6) versehen ist,

dadurch gekennzeichnet,

daß das elektrisch isolierende Substrat (2) sowohl auf seiner Ober- als auch auf seiner Unterseite Halbleiterchips (1) und je eine Abdeckhaube (5) mit daran befestigtem Kühlkörper (6) trägt sowie Leiterzüge, die von Kontaktflächen (3) ausgehen, die an den Rändern des Substrates (2) vorgesehen sind,

daß an die Kontaktflächen (3) auf der Oberseite des Substrates (2) Kontaktfedern (4) angelötet sind,

daß das mit Halbleiterchips (1), Abdeckhauben (5) und Kühlkörpern (6) versehene Substrat (2) in die Aussparung (9) einer Grundkarte (12) eingesetzt ist, die an ihren Rändern auf der Ober- und Unterseite mit Kontaktflächen (10) versehen ist,

daß die freien Enden der auf der Oberseite des Substrates (2) angelöteten Kontaktfedern (4) die Kontaktflächen (10) auf der Oberseite der Grundkarte (12) kontaktieren,

daß an die Kontaktflächen (10) der Unterseite der Grundkarte (12) Kontaktfedern (13) angelötet sind, deren freies Ende die Kontaktflächen (3) auf der Unterseite des Substrates (2) kontaktiert,

daß an zwei gegenüberliegenden Seiten jedes Kühlkörpers (6) zwei Verriegelungsbügel (7) aus federndem Material, die an ihren freien Enden einen Vorsprung (8) aufweisen, befestigt sind, die unter Nasen (14) von auf der Grundkarte (12) befestigten Verriegelungsposten (11) einrasten und das Substrat (2) in seiner Position festhalten.

2. Trägeranordnung nach Anspruch 1,
dadurch gekennzeichnet,
daß die Verriegelungsbügel (7) aus einer Legierung oder einem Kunststoff bestehen.

3. Trägeranordnung nach Anspruch 2,
dadurch gekennzeichnet,
daß die Verriegelungsbügel (7) aus einer Kupfer-Beryllium-Legierung bestehen.

4. Trägeranordnung nach Anspruch 2,
dadurch gekennzeichnet,
daß die Verriegelungsbügel (7) aus Phosphorbronze bestehen.

5. Trägeranordnung nach Anspruch 1,
dadurch gekennzeichnet,
daß die Kontaktfedern (4, 13) aus einer Kupfer-Beryllium-Legierung bestehen und im Kontaktbereich goldplattiert sind.

## Claims

1. Carrier arrangement for semiconductor chips (1), comprising monolithically integrated circuits, which are soldered to an electrically insulating substrate (2) provided with internal and external conductors feeding the input and output signals as well as the supply voltages, and which has a cover (5) and a cooling element (6) fixed thereto,
characterized in that the electrically insulating substrate (2) carries both on its top and its bottom side semiconductor chips (1) and one cover (5) each with a cooling element (6) fixed thereto, as well as conductors starting at contact faces (3) provided along the edges of the substrate (2),
that contact springs (4) are soldered to the contact faces (3) on the top side of the substrate (2),
that the substrate (2), provided with semiconductor chips (1), covers (5) and cooling elements (6), is inserted into the recess (9) of a basic card (12) having contact faces (10) along its edges on the top and the bottom side,
that the free ends of the contact springs (4) soldered to the top side of the substrate (2) contact the contact faces (10) on the top side of the basic card (12),
that contact springs (13) are soldered to the bottom side of the basic card (12), the free end of which contacts the contact faces (3) on the bottom side of the substrate (2),
that to two opposite sides of each cooling element (6) two locking brackets (7) of resilient material are fixed, the free ends of which are provided with a protrusion (8), said locking brackets engaging noses (14) of locking posts (11), fixed to the basic card (12), and keeping substrate (2) in its position.

2. Carrier arrangement as claimed in claim 1, characterized in that the locking brackets (7) are made of an alloy or plastic.

3. Carrier arrangement as claimed in claim 2, characterized in that the locking brackets (7) are made of a copper beryllium alloy.

4. Carrier arrangement as claimed in claim 2, characterized in that the locking brackets (7) are made of phosphor bronze.

5. Carrier arrangement as claimed in claim 1, characterized in that the contact springs (4, 13) are made of a copper beryllium alloy and are gold-plated in the contact region.

## Revendications

1. Dispositif de support pour des microplaquettes à semiconducteurs (1), qui contiennent des circuits intégrés monolithiques et sont soudées sur un substrat électriquement isolant (2), qui comporte des voies conductrices internes et externes, au moyen desquelles sont envoyés les signaux d'entrée et de sortie ainsi que les tensions d'alimentation, et un capot de revêtement (5) et des dissipateurs de chaleur (6) fixés à ce capot,
caractérisé par le fait
que le substrat électriquement isolant (2) porte des microplaquettes à semiconducteurs (1) aussi bien sur sa face supérieure que sur sa face inférieure, et respectivement un capot de revêtement (5) auquel est fixé un dissipateur de chaleur (6), ainsi que des voies conductrices, qui s'étendent à partir de surfaces de contact (3) prévues sur les bords du substrat (2),
que des ressorts de contact (4) sont soudés sur les surfaces de contact (3) sur la face supérieure du substrat (2),
que le substrat (2), équipé des plaquettes à semiconducteurs (1), des capots de revêtement (5) et des dissipateurs de chaleur (6), est inséré dans l'évidement (9) d'une carte de base (12), qui comporte des surfaces de contact (10) au niveau de ses bords sur la face supérieure et sur la face inférieure,
que les extrémités libres des ressorts de contact (4) soudés sur la face supérieure du substrat (2) sont en contact avec les surfaces de contact (10) situées sur la face supérieure de la carte de base (12),
que sur les surfaces de contact (10) de la face inférieure de la carte de base (12) sont soudés des ressorts de contact (13), dont l'extrémité libre est en contact avec les surfaces de contact (3) situées sur la face inférieure du substrat (2),
que sur deux faces opposées de chacun des dissipateurs de chaleur (6) sont fixés deux étriers de blocage (7) réalisés en un matériau élastique, qui possèdent une partie saillante (8) au niveau de leurs extrémités libres, s'encliquettent au-dessous de becs (14) de montants de blocage (11) fixés sur la carte de base (12) et fixent le substrat (2) dans sa position.

2. Dispositif de support selon la revendication 1, caractérisé en ce que les étriers de blocage (7) sont réalisés en un alliage ou une matière plastique.

3. Dispositif de support selon la revendication 2, caractérisé en ce que les étriers de blocage (7) sont réalisés en un alliage de cuivre-béryllium.

4. Dispositif de support selon la revendication 2, caractérisé en ce que les étriers de blocage (7) sont réalisés en bronze phosphoreux.

5. Dispositif de support selon la revendication 1, caractérisé en ce que les ressorts de contact (4,13) sont réalisés en un alliage de cuivre-béryllium et comportent un placage d'or dans la zone de contact.

FIG. 1

FIG. 2